# EUROPEAN PATENT APPLICATION

(11) **EP 1 564 561 A1**
(43) Date of publication of application: **17.08.2005**
(21) Application number: 05100227.7
(22) Date of filing: 17.01.2005
(51) Int. Cl.: G01R 31/04

(54) **Detecting connectivity of a speaker**

(30) Priority: 10.02.2004 US 776937
(71) Applicant: BOSE CORPORATION, Framingham, Massachusetts 01701-9168 (US)
(72) Inventor: Cheney, Maynard C., Framingham MA Massachusetts 01701-9168 (US); Cronis, Lewis T., Framingham MA Massachusetts 01701-9168 (US)
(74) Representative: Brunner, Michael John

(57) **Abstract**

There are techniques described to determine connectivity of a speaker. An amplifier is driven in a predefined manner. A change in power delivered to a power input of the amplifier (or an electrical apparatus in which the amplifier is incorporated) as a result of the predefined driving is sensed. A value indicative of a state of connection of one or more speakers to an output of the amplifier is determined, based on the sensed change in power.

## Description

### BACKGROUND

This application relates to detecting connectivity of a speaker.

Detecting whether a speaker is connected to an output of an audio or multimedia system (and if so the type of speaker that is connected) is sometimes difficult if done using only visual or auditory senses, for example, when the system and speaker are installed in an automobile. Detecting speaker connectivity can be important during installation or maintenance of the system.

### SUMMARY

In one aspect, there is a method to detect connectivity of a speaker. The method includes driving an amplifier in a predefined manner and sensing a change in power delivered to a power input of the amplifier (or an electrical apparatus in which the amplifier is incorporated) as a result of the predefined driving. The method also includes determining a value indicative of a state of connection of one or more speakers to an output of the amplifier, based on the sensed change in power.

The method can be implemented to include one or more of the following advantageous features. Sensing the change in power can include sensing a change in power delivered to a power input of an apparatus that includes the amplifier as a result of the predefined driving. Sensing the change in power can include sensing a change in power transmitted from a power supply supplying the amplifier as a result of the predefined driving. Sensing the change in power can include measuring a current. Determining the value can include comparing the sensed change to a plurality of stored changes, where each stored change corresponding to possible states of connection of the one or more speakers, and selecting a stored change closest to the sensed change. Driving the amplifier in a predefined manner can include applying a driving signal of known frequency and amplitude to the amplifier. Driving the amplifier in a predefined manner can include applying a driving signal with characteristics which prevent the amplifier output from causing an audible effect. Determining a value can include determining an impedance seen at the output of the amplifier.

The method can include comparing the determined value to an expected value for the one or more speakers. The expected value can include an impedance of the one or more speakers. The expected value can include an impedance of the one or more speakers operating at a frequency of a signal driving the amplifier. Measurement of the current input to an apparatus which incorporates one or more amplifiers, each of which drives one or more independent output channels, permits diagnosing faults at any individual output. The test conditions used to detect output faults can be selected to optimize the ability to detect fault conditions when multiple loads connected to a single output have impedance curves which overlap at some frequencies. The test conditions used to detect output faults can be selected to minimize the audible effect resulting from applying the probing signals to the amplifier input(s).

The state of connection can include two speakers connected to the output of the amplifier. Driving the amplifier in a predefined manner can include applying at least one probing signal. The two speakers can be connected to the channel and more than one probing signal can be used to drive the amplifier. The probing signal can be selected to be outside a normal range of hearing. The probing signal can be a single pulse comprising a shape that is selected to minimize an audible effect of energizing a drive coil of a DC-connected speaker. The change can include an input supply current change of the amplifier. Determining the value can include performing noise rejection. Performing noise rejection can include performing noise rejection using synchronized demodulation. Performing noise rejection can include performing noise rejection using correlation analysis.

In another aspect, there is an system that includes an amplifier and a circuit. The amplifier has a speaker output, a drive signal input, and a power input. The circuit is connected in a manner to determine whether and which speaker or speakers are connected to the speaker output based on a detected amount of power being drawn at the power input.

The system can be implemented to include one or more of the following advantageous features. The system can include a current supply electrically connected to the power input of the amplifier. The circuit can include an inductor across which a voltage measurement can be made, the inductor being electrically connected between the current supply and the power input of the amplifier. The inductor can include a low resistance portion and a low inductance portion. The circuit can include a resistive circuit board trace with two points between which a voltage drop can be measured, the resistive circuit board trace being electrically connected between the current supply and the power input of the amplifier. The circuit can include a signal measurement module. The circuit can detect the amount of power being drawn at the power input of the amplifier by sensing an amount of power transmitted from a power supply electrically connected to the power input of the amplifier. The system can include an apparatus that includes the amplifier, where the circuit detects the amount of power being drawn at the power input of the amplifier by sensing an amount of power drawn at a power input of the apparatus. The amplifier can a first amplifier, and the system can include a second amplifier that is included in the apparatus, where the first and second amplifiers each have one or more speaker outputs and are capable of being driven independently. The circuit can be configured to sense an amount of power drawn at a power input of the apparatus while driving each amplifier independently, making it possible to diagnose output faults each output channel of each amplifier using the sensed power at the apparatus.

In another aspect, there is a computer program product, tangibly embodied in an information carrier, for detecting connectivity of a speaker, where the computer program product includes instructions operable to cause data processing apparatus to perform any of the methods or features described above.

Implementations can realize one or more of the following advantages. The detection system can be tuned specifically for the speaker combination in use with each individual channel driven by a particular amplifier in a particular vehicle. The detection system is low-cost, as only a current sense circuit needs to be added to a host system (e.g., the system already present to drive the amplifier under normal operating conditions). The other components of the detection system can be implemented using the existing components of the host system. The detection system can diagnose all channels. The detection system can be optimized for minimal audio artifacts.

Other features, aspects, and advantages of the invention will become apparent from the description, the drawings, and the claims.

### DESCRIPTION

- FIG. 1: is a block diagram of a connectivity detection system.
- FIG. 2: is a graph of signals over time.
- FIG. 3: is a graph of speaker impedance versus frequency.
- FIGs. 4 and 5: are block diagrams of connectivity detection systems.
- FIG. 6: is a block diagram of an example synchronized demodulation module.
- FIGs. 7 and 8: are out of phase examples of synchronized demodulation.

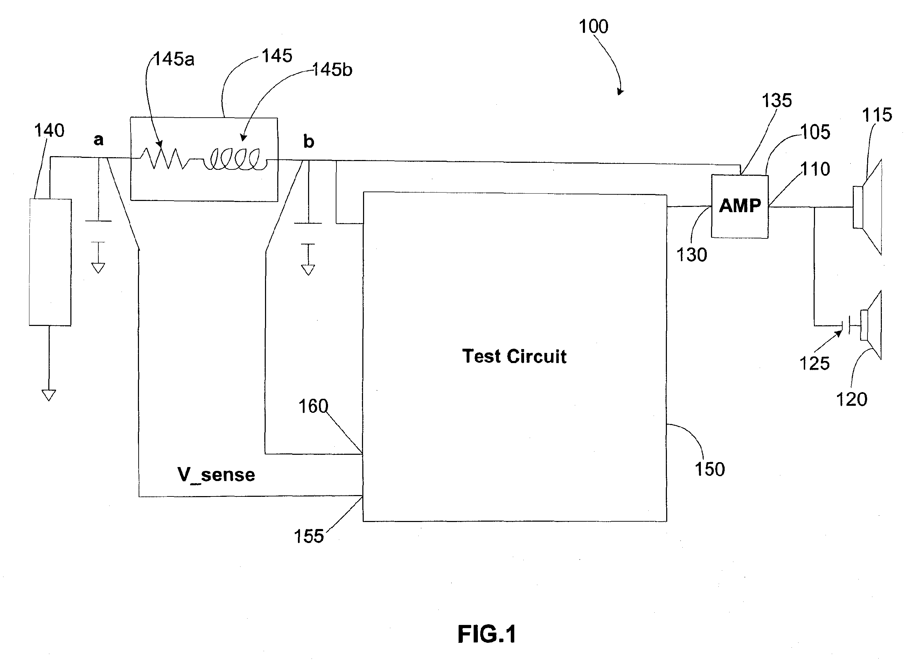

In FIG. 1, a detection system 100, for detecting connectivity of a speaker, includes an amplifier 105 shown (in this example) with one output channel 110 that drives a midrange speaker 115 and a tweeter 120. Tweeter 120 is electrically connected to channel 110 through a series capacitor 125. In operation, amplifier 105 receives an input drive signal from a source (not shown) through its input drive signal port 130 that controls how amplifier 105 drives speakers 115 and 120. The input drive signal may contain information representing, for example, music, and is a relatively low power signal that cannot drive the speakers at a usable volume level. The amplifier 105 produces an output signal on channel 110 that faithfully reproduces the input drive signal on port 130 and carries enough power to drive the speakers 115 and 120 to a usable volume level. For this purpose, amplifier 105 draws current at its input supply port 135 from a power supply 140 (for example an automobile battery, a battery in combination with a generator or an alternator, or other power source) through a sense component 145. The sense component 145 represents any component that provides a sense signal that is proportional to the current flowing through the sense component 145. For example, a resistor can be a sense component because a resistor has a voltage drop across it proportional to the current flowing through it (e.g., v=i*r). The examples of FIGs. 1, 4, and 5 use an inductor as the sense component 145.

To transmit a test signal (also referred to as a probing signal) to the input drive signal port 130 of the amplifier 105 and measure a change in current across sense component 145, system 100 includes a test circuit 150. The goal of the test circuit 150 is to detect whether and, if so, which speaker or speakers are connected to each output of the amplifier (there may be other outputs of the amplifier in addition to the one shown in the figure) without making a user look at the electrical connections or listen to the system. Each speaker that may be connected to the output of the amplifier is characterized by a signature impedance versus frequency curve, so that at a certain frequency, the amplifier 105 needs a certain amount of input current at the input supply port 135 to be able to drive the speakers 115 and 120. Driving the amplifier 105 with a test signal at a specific frequency and magnitude causes an increase in current to the input supply port 135 of the amplifier 105 by some expected amount, based on e.g., the signature curves of the speakers 115 and 120 at the specific frequency and other factors of the amplifier 105, such as its efficiency at the specific frequency. As explained in more detail below, by measuring a signal change across the sense component 145 in response to a predefined test signal, and comparing the measured value against an expected value using the predefined test signal, the test circuit 150 can determine the connectivity of speakers 115 and 120.

In the example illustrated in FIG. 1, test circuit 150 measures a voltage drop occurring across an inductor 145 while the test circuit 150 delivers an input drive signal of known power and frequency to the input 130 of the amplifier 105. In the illustrated examples, the sense component 145 is referred to as the inductor 145, which is a component present in the power input circuit to the amplifier 105. As described above, however, any sense component interposed between the source of power to the amplifier (e.g., power supply 140) and the amplifier itself (e.g., 105) can serve to measure a change in power supplied to the amplifier 105. As described below, such a sense component might be e.g. a section of a circuit board trace running from the power supply 140 to the amplifier 105.

When a true inductor supplies the sense resistance, e.g. Inductor 145 in Fig. 1, its equivalent circuit includes a low resistance portion 145a and a low inductance portion 145b. As current travels from power supply 140 to amplifier 105, there is a small voltage drop across inductor 145 due to its low resistance portion 145a. The voltage drop across inductor 145 is proportional to the magnitude of the current flowing from the power supply 140 through inductor 145 and to the amplifier 105. (Because an inductor is a reactive component, the relationship between voltage and current may have a frequency dependence that is known and can be compensated for when making calculations, since the test signal is generated at a predetermined frequency.) The amount of current flowing to the amplifier 105 is determined by how much current the amplifier 105 needs to draw from the power supply 140 to drive the speakers 115 and 120 in accordance with the signal at the drive signal input 130 of the amplifier 105. The amount of current drawn by the amplifier 105 for that purpose also depends on the impedance of the speakers 115 and 120 at the frequency of the input drive signal. Therefore, the amount of current flowing through inductor 145 is a function of the magnitude and frequency of the input drive signal to the amplifier 105 and of the impedance of the speakers 115 and 120 at that frequency.

The test circuit 150 has two monitoring ports 155 and 160 connected to points a and b on the two sides of the inductor 145. The sense signal change characteristics vs. probe signal frequency, and specifically impedance characteristics versus frequency of speakers that may be connected to the output 110 of the amplifier 105 are determined by testing units of the speakers 115 and 120 prior to the time when the connectivity detection process is to occur. The frequency and amplitude points at which the testing is to be performed are selected to optimize the ability of the test circuit 150 to discriminate between the possible combinations of speakers which are correctly installed and information about the expected measurement results for these selected test conditions is stored in the test circuit 150.

In operation, to detect speaker connectivity, test circuit 150 is programmed to provide a probing signal into input drive signal port 130 of amplifier 105. The probing signal may have a specific selected known frequency and magnitude, or a series of probing signals of different known frequencies or magnitudes may be delivered. Because test circuit 150 knows the previously measured sense signal change characteristics or impedance of speakers, like speakers 115 and 120, at the specific frequency and magnitude (or frequencies and magnitudes), test circuit 150 knows what the sense signal change or impedance is expected to be seen at the output of amplifier 105. For example, if a particular tweeter and a particular mid-range speaker are expected to be connected to the output of the amplifier 105, the test circuit expects to see an impedance at the output of the amplifier 105 that corresponds to the known impedance curves of the tweeter and mid-range at the probing signal frequency.

If synchronous demodulation is not used, the measured voltage across the sense resistance will include a signal component that is present regardless of the frequency and magnitude of the drive signal to the amplifier (e.g., the signal component resulting from the base or idle current input to the amplifier 105). In such a case, prior to delivery of the probing signal, the test circuit 150 measures the voltage across the inductor at ports 155 and 160 and stores a corresponding value as an indicator of the base current carried through the inductor 145 when the amplifier 105 is not being driven. During the delivery of the probing signal, test circuit 150 monitors the voltage across the inductor at ports 155 and 160. Test circuit 150 uses the monitored voltage to calculate a change in current caused by the probing signal. This change represents the change in current supplied to amplifier 105 in response to the probing signal. This current change information can be used to determine speaker connectivity if prior test saved expected values are current change characteristics. Furthermore if prior test saved expected values are impedance, using this change and known information about the magnitude and frequency of the probing signal (or signals), test circuit 150 can calculate the output impedance of amplifier 105 and compare that calculated value to the expected value to determine whether none, one, or both of speakers 115 and 120 are electrically connected to channel 110 of amplifier 105.

To calculate the impedance seen at the output of amplifier 105, test circuit 150 determines the current flow through inductor 145, by measuring the voltage at point a and subtracting the voltage measured at point b. The result equals the voltage drop across inductor 145. Conceptually, test circuit 150 takes this calculated voltage drop and divides the voltage drop (V) by a known value of the impedance (R) of inductor 145, using the equation I=V/R, to calculate the current (I). For a simple example, if the voltage at point a is 11.50 volts and the voltage at point b is 11.45 volts, then the voltage drop across inductor 145 is 0.05 volts. If the resistance of inductor 145 is 0.1 ohms, then the current flow is 0.5 amperes. Test circuit 150 calculates the current through inductor 145 both before and after test circuit 150 initiates a probing pulse.

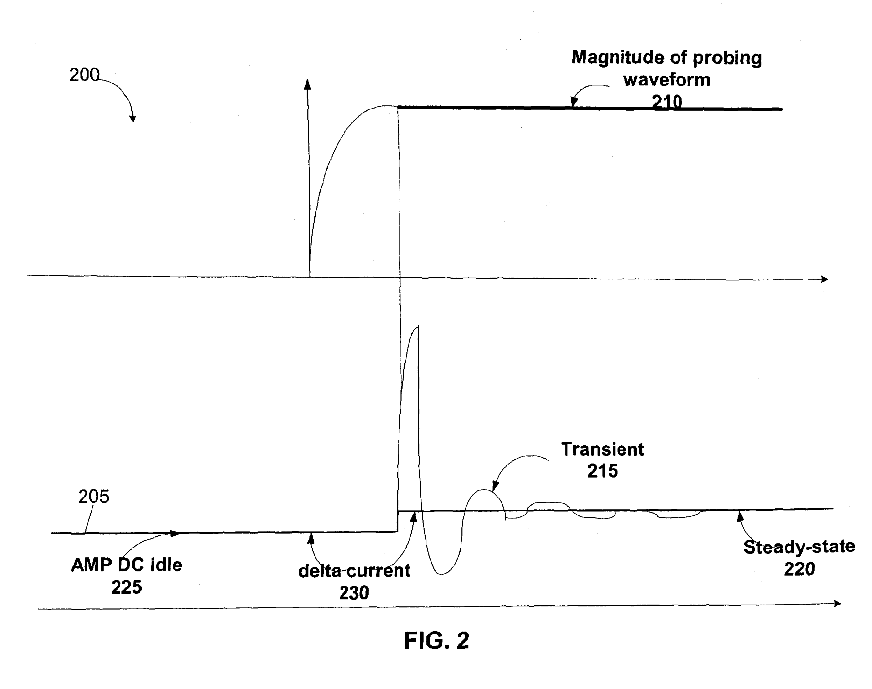

The graph of FIG. 2 depicts a graph 200 that includes a plot of current 205 through inductor 145 over time and a plot of the magnitude of a probing signal 210 transmitted to input drive signal port 130. FIG. 2 shows how, under normal conditions, the current increases when test circuit 150 initiates probing signal 210. (If neither speaker 115 nor 120 were connected to channel 110, then current signal 205 would not change, and the test circuit could therefore detect the non-connection of both speakers). When the current abruptly changes, there is first a transient response 215 until the current signal 205 reaches a steady-state level 220. In FIG. 2, steady state response 220 is the value from which the value of amplifier idle current 225 (the current value before probing signal 210 is initiated) is subtracted to calculate the change 230 in current due to probing signal 210. Using the simple example above, if the idle current 225 before the probing pulse is 0.5 amperes and the steady state current 220 after the probing signal 210 is 1.0 amperes, then the change in current 230 is 0.5 amperes.

Using the calculated change in current, test circuit 150 can calculate the impedance seen at the output of amplifier 105 provided that test circuit 150 has stored a calibration factor which is derived from the change in current observed for the same probing pulse when a known impedance is connected to the output of the amplifier 105. Such a calibration factor can be derived e.g. during the manufacturing process, when the amplifier 105 is connected to a test apparatus consisting of fixed, known purely resistive loads. The calibration factor, thus derived, empirically corrects the measurement for inaccuracies resulting from e.g. the manufacturing tolerance of the DC resistive component of the inductor, the calibration of the sensing, processing, and measuring means, and the efficiency of the amplifier 105 at the frequency of the probing pulse. More generally, the calibration factor is a lumped constant which includes the electronic variability (e.g., DC resistance of inductor, gain of signal processing, volts per A/D count, efficiency of amplifier) and the test conditions (e.g., amplitude and frequency of test signal, number of samples taken). Lumping the constant is a computational convenience that makes it unnecessary to normalize the measurements or convert them to actual voltage and current units.

For example, for a given set of test conditions, the expectation is that the sum of N A/D conversions of the output of the sensor circuit will be proportional to the change in output current when the probe signal is applied, which is in turn inversely proportional to the connected resistance. So if S total A/D counts are measured with a known resistance of R ohms, then S = k * (1/R), where k is the calibration factor. From this, k can be determined by rearranging the equation to k = S * R, where R is the known quantity and S is the measurement. Now when an unknown resistance is used (e.g., speakers whose connection is unknown), the same relationship will hold but this time the unknown is R' and k is known. If a sum S' for an unknown resistance R' is measured, then S' = k / R' or R' = k / S'. In one example for a car audio system, k has a value of 25500 when 64 samples are taken.

Test circuit 150 compares the calculated load impedance to the expected value of the combined impedance of speakers 115 and 120 at the frequency of the probing signal. If the two values are equal within experimental error, then test circuit 150 has confirmed that speakers 115 and 120 are indeed electrically connected to channel 110 of amplifier 105.

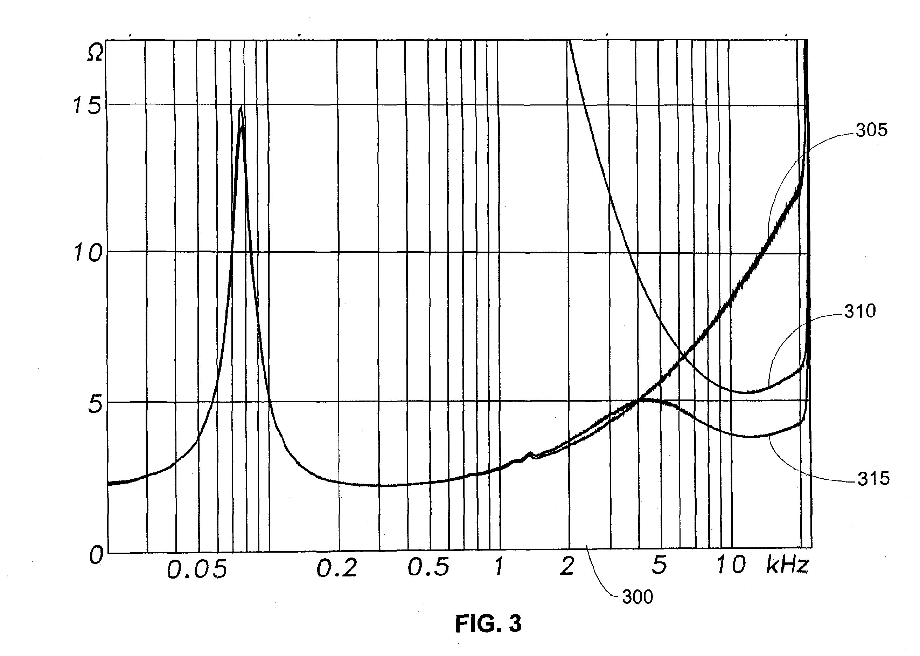

In FIG. 3 graph 300 shows example impedances for speakers 115 and 120 as a function of frequency. Graph 300 includes plots 310, 315, and 320 showing the impedance curves for speaker 115 alone (305), for speaker 120 alone (310), and the parallel combination of speakers 115 and 120 (315).

Test circuit 150 can use different criteria for selecting the frequency of the probing signal. For example, one criterion can be using a frequency where the impedance of the speakers, alone or in combination, are different (e.g., substantially different) from each other (e.g., where plots 305, 310, and 315 each have different values and do not overlap). As will be described shortly, this enables testing circuit 150 to determine which speakers (115 and/or 120) are connected to channel 110. Another criterion can be using a frequency that does not create an audio effect. In other words, selecting a frequency outside of the audible range, which is generally considered 16 Hz to 20 kHz. Using the example frequency responses of graph 300, the frequency of 20 KHz will be used to illustrate how testing circuit 150 can determine which speakers are connected to channel 110.

Using graph 300, if both speakers 115 and 120 are connected to channel 110, then the impedance connected to amplifier 105 should be about 3.8 ohms at 20 KHz according to plot 315. If only speaker 120 is connected to channel 110, then the impedance connected to amplifier 105 should be about 5.5 ohms at 20 KHz according to plot 310. If only speaker 115 is connected to channel 110, then the impedance connected to amplifier 105 should be about 12 ohms at 20 KHz according to plot 305. If test circuit 150 uses a probing signal with a frequency of 20 kHz and a predetermined amplitude (e.g., 1.9 volts), then, as described above test circuit 150 can calculate a measured value for the output impedance of the amplifier using R' = k / S', where k has previously been calculated for the system and S' is the measured value. If test circuit 150 calculates an output impedance of 3.8 ohms, which is the expected value when both speakers 115 and 120 are connected, then test circuit 150, with this measurement and comparison to the expected value on the graph, has verified that both speakers are connected. If test circuit 150 calculates the output impedance to be 5.4 ohms, which is the expected value when only speaker 120 is connected, then with this measurement and comparison to the data of graph 300, test circuit 150 can determine that only speaker 120 is connected and initiate a notification to the user (e.g., logging a fault code or transmitting a message to a display of the audio system). Similarly, if test circuit 150 calculates an output impedance of 11.9 ohms, which is the expected value when only speaker 115 is connected, then with this measurement and comparison to the data of graph 300, test circuit 150 can determine that only speaker 115 is connected and initiate a notification to the user (e.g., logging a fault code or transmitting a message to a display of the audio system). As described above, if there were no measured change in current, test circuit 150 can determine that neither speaker 115 nor 120 is connected and take appropriate action. A current change larger than that expected with the correct speaker configuration indicates the presence of a faulty speaker or shorted output connection. This example illustrates how detection circuit 100 can be customized for the specific speaker combination connected to channel 110. In other words, test circuit 150 can be "tuned" to the speaker combination connected to channel 110, simply by providing to test circuit 150 the frequency response impedance data for the speaker combination.

The examples above describe how system 100 determines the output impedance of amplifier 105 to determine connectivity of speakers 115 and 120. During the testing operation, the load presented to the power supply 140 changes when the input signal to the amplifier 105 changes, or the load on the amplifier 105 changes. As described above, a lumped parameter, such as the calibration factor, can include all variability of the loads (e.g., the sensing component 145, the amplifier 105, and the speakers 115 and 120) of power supply 140 at different test signals (e.g., frequencies and magnitudes) applied to input port 130. Although using the calibration factor, the impedances can be determined from measured sense signal as shown, from theses examples, it can be seen that the techniques do not have to be limited to measuring and comparing impedances. All that is needed is to measure a sense signal such as changes in current drawn by the amplifier 105 (e.g., current output of the power supply 140) for particular test signals, and to choose the parameters of the applied test signals such that the various possible failure modes (e.g., both speakers 115 and 120 connected, only speaker 115 connected, only speaker 120 connected, or neither speakers connected) result in detectable differences in this measured current.

As described above, the power drawn by the amplifier 105 (or simplified to just current drawn by the amplifier 105) under the various conditions for each input signal used is determined and stored in test circuit 150. For example, using the signature curves of FIG. 3, a resistive load of 3.8 ohms (representing both speakers 115 and 120 are connected to channel 110) is connected to the amplifier 105 and a test signal of 20 KHz is applied to port 130 of amplifier 105. The change in current across inductor 145 is measured and stored. This stored value, the expected value, has automatically compensated for any frequency dependence of inductor 145 and efficiencies of amplifier 105. Similarly, measurements can be made and stored using a resistive load of 5.5 ohms (representing only speaker 120 connected to channel 110) and a resistive load of 12 ohms (representing only speaker 115 connected to channel 110). Then, during operation, actual measurements of power (or current) drawn from the power supply 140 are made by test circuit 150 for an input signal of 20 KHz, and compared to the stored result. While one curve is used for one set of speakers, multiple measurements can be made for all possible combinations of speakers that will be used in system 100 so that test circuit 150 can make connectivity determinations for any of the combinations that might be used.

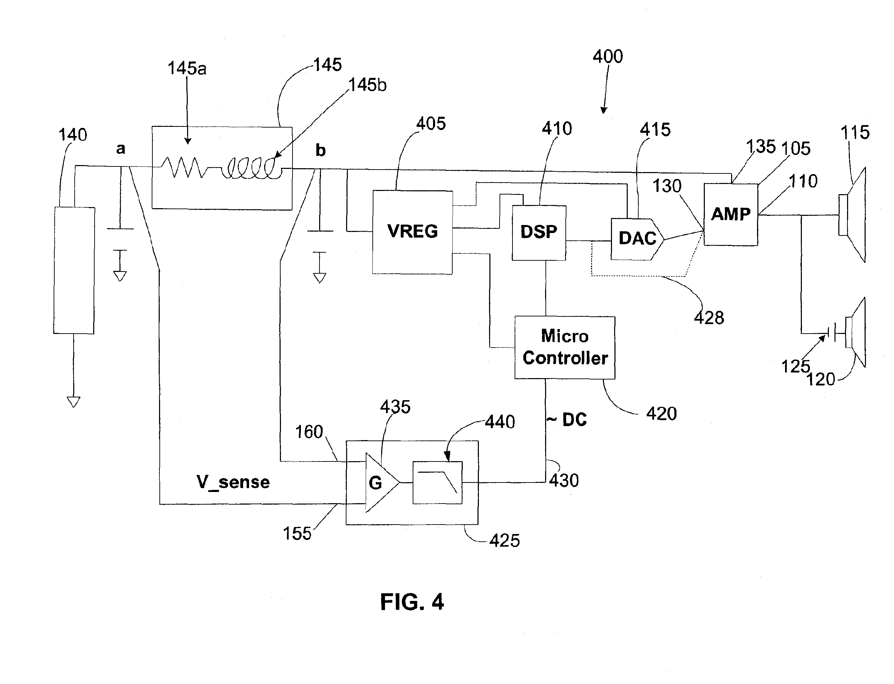

The examples above use a test circuit 150 that performs all of the functions to determine connectivity of the speakers 115 and 120. In other examples, all or some of a portion of test circuit 150 can be implemented using components of a host system (e.g., the system already present to drive the amplifier under normal operating conditions). FIG. 4 illustrates an example detection circuit 400 where components of a host system are used. In detection system 400, the host system includes a voltage regulator (VREG) 405, a digital signal processor (DSP) 410, a digital to analog converter (DAC) 415, and a micro controller 420. Detection system 400 also includes a signal measurement module 425 to measure the voltages between points a and b.

In detection system 400, micro controller 420 coordinates most of the activities to perform the detection techniques described above. Micro controller 420 sends a signal to DSP 410 to initiate a probing signal of a certain frequency and a certain magnitude. In response to the initiation, DSP 410, using DAC 415, transmits a probing signal to amplifier 105. If amplifier 105 can receive digital signals directly, then DSP 410 can transmit a probing signal directly to amplifier 105 using connection 428, instead of using DAC 415. Micro controller 420 can control amplifier 105 to operate in a different mode, such as a diagnostic mode, when transmitting the probing signal.

Micro controller 420 also receives a current measurement from signal measurement module 425 both before initiation of the probing signal and after the probing signal has been transmitted to amplifier 105. Signal measurement module 425 transmits the current measurement from its output port 430. Micro controller 420 includes an analog to digital converter (ADC) to convert samples of the current measurement to digital words. Micro controller 420 includes stored software instructions to calculate the change in current in response to the probing signal and the calculate output impedance of the amplifier using the techniques described above, if necessary. Micro controller 420 also includes data (e.g., in persistent memory) of the frequency response of impedance for the connected speakers 115 and 120, to make the comparisons to the calculated values.

To make the current measurements, one implementation of signal measurement module 425 includes a high-side current sense amplifier 435 with internal gain and a low pass filter 440. The high-side current sense amplifier 435 with internal gain can be for example, an operational amplifier with resistors or an integrated circuit (e.g., part number MAX4376, manufactured by Maxim Integrated Products of Sunnyvale, CA). The output of the current sense amplifier 435 can be processed so that its output is proportional to the current, for example 1 volt per ampere. Low pass filter 440 filters out high frequency noise.

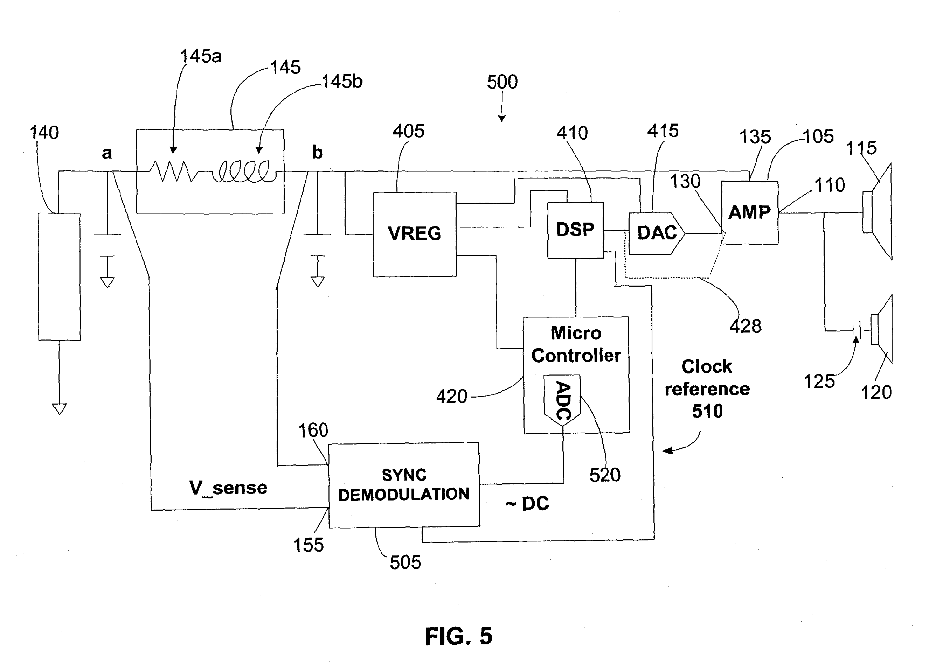

FIG. 5 illustrates another example detection circuit 500 where components of a host system are used. Detection circuit 500 is similar to detection circuit 400 except the signal measurement module is a synchronized demodulator 505. Synchronized demodulator 505 is synchronized with DSP 410 using a clock reference signal 510 (frequency and phase). Synchronized demodulation advantageously rejects non-synchronized noise sources, such as interference and pickup. Synchronous demodulation is a technique that advantageously improves the ability of the system 100 to detect changes in power drawn from power supply 140 that are related to the signal applied to the amplifier load (e.g., it removes the bias component of current drawn by the amplifier 105 from the measurement because it includes a frequency discrimination aspect). In the illustrated example, the output of the synchronized demodulator 505 is electrically connected to an analog to digital converter (ADC) 520 that is included in the micro controller 420.

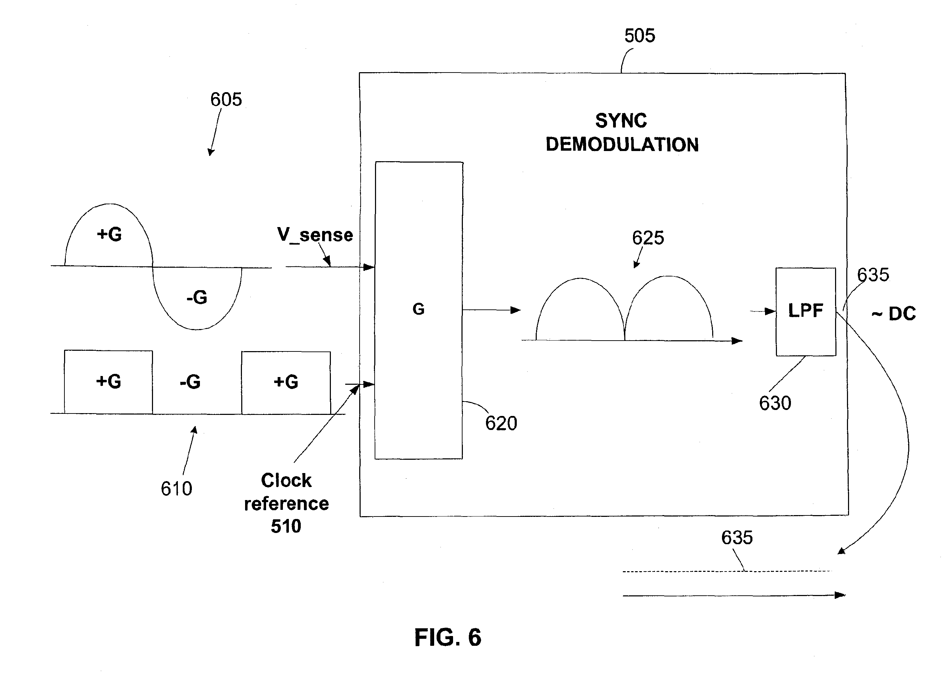

FIG. 6 illustrates operation of synchronized demodulator 505 in more detail. FIG. 6 includes an example waveform 605 of the V_sense signal received at ports 155 and 160 (FIG. 5) and an example waveform 610 of the clock reference signal 510. As the waveforms enter a gain block 620, the V_sense waveform 605 is demodulated using the clock reference waveform 610, to generate the waveform 625. In the illustrated example, waveform 605 is in phase with waveform 610. The demodulated waveform 625 is transmitted through a low pass filter 630 to produce an average DC value signal 635. The output of low pass filter 630 is transmitted to micro controller 420 (FIG. 5) for use in current and impedance calculations as described above.

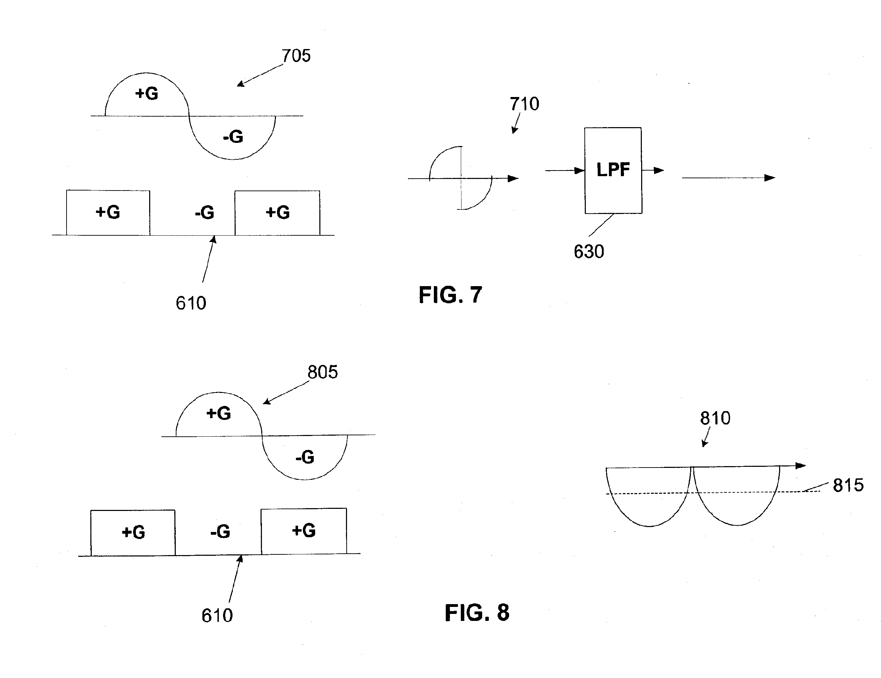

FIGs. 7 and 8 illustrate example signals that are phase shifted with respect to the clock waveform 610. In FIG. 7, waveform 705 is 90° phase shifted with respect to waveform 610. The resulting waveform 710 generated by the synchronized demodulator 505 does not have a DC component, so there is no DC component on the output of low pass filter 630. The signal 705 is rejected because it is out of phase with waveform 610. In FIG. 8, waveform 805 is 180° phase shifted with respect to waveform 610. The resulting waveform 810 generated by the synchronized demodulator 505 has a negative DC component 815.

In operation, the micro controller 420, using the ADC 520, measures V_sense with the clock reference 510 in phase (e.g., 0° phase shift) with the output probing signal of the DSP 410. This can be referred to as the in phase component of the current sense signal. The micro controller 420, using the ADC 520, also measures V_sense with the clock reference 510 phase shifted (e.g., 90° phase shift) with the output probing signal of the DSP 410. This can be referred to as the quadature component of the current sense signal. Using both of these measured signals, the micro controller 420 calculates the in phase signal. There is no need to measure (and subsequently subtract from later measurements) the DC offset caused by the amplifier's 105 overall idle current because a DC level present to the input of the synchronous demodulator 505 averages to zero. This is due to the fact that the gain switches synchronously via the clock input from +G to -G, the DC average of which is zero. As shown in FIGs. 6-8, the synchronous detection measure the in phase signal amplitude and rejects out of phase/quadature components.

In another example (not shown) two synchronous demodulators 505 and two ADCs 520 can be used to measure the in phase component and the quadature component of the current sense signal in parallel. The use of both an in phase component and a quadature component improves the accuracy of measurement. Measuring the quadature component is not necessary, however. Some of the techniques described above include relative measurements, as opposed to absolute measurements, and a small error signal caused by quadature signal components is constant for the duration of the measurements, and so small error signal could be accounted for in relative calculations (or at least be negligible).

Other embodiments are within the scope of the following claims.

For illustrative example only and not to limit alternatives in any way, for sensing current, a voltage measurement can be taken anywhere along the connecting circuit between power supply 140 and input supply port 135. If a circuit board trace has a known resistance per length of trace, the measured voltage drop across a predetermined length can be used to calculate the current flow using to the techniques described above. Also, amplifier 105 can include multiple channels and/or amplifiers and the techniques described above can be used to determine connectivity for each channel of each amplifier. In one example, one or more probing signals are transmitted to each amplifier separately and speaker connectivity is determined for that specific amplifier when the probing signals are applied.

Also, although in the examples discussed, the impedance was measured as exactly the value expected, it is also possible to infer which speaker or speakers are connected based on the proximity of the measured impedance valued to the expected value. As another alternative, the averaging of measurement fluctuations and rejecting noise sources of the signal measurement module can be performed using correlation analysis in the micro controller. For example, the micro controller can save a number of analog to digital conversions from the signal measurement module and perform postprocessing, such as using fast Fourier transforms (FFT) for correlation analysis.

## Claims

1. A method comprising
driving an amplifier in a predefined manner,
sensing a change in power delivered to a power input of the amplifier as a result of the predefined driving, and
determining a value indicative of a state of connection of one or more speakers to an output of the amplifier, based on the sensed change in power.

2. The method of claim 1, in which sensing the change in power comprises sensing a change in power delivered to a power input of an apparatus that includes the amplifier as a result of the predefined driving.

3. The method of claim 1, in which sensing the change in power comprises sensing a change in power transmitted from a power supply supplying the amplifier as a result of the predefined driving.

4. The method of claim 1, in which sensing the change in power comprises measuring a current.

5. The method of claim 1, in which determining the value comprises
comparing the sensed change to a plurality of stored changes, each stored change corresponding to possible states of connection of the one or more speakers; and
selecting a stored change closest to the sensed change.

6. The method of claim 1, in which driving the amplifier in a predefined manner comprises applying a driving signal of known frequency and amplitude to the amplifier.

7. The method of claim 1, in which driving the amplifier in a predefined manner comprises applying a driving signal with characteristics which prevent the amplifier output from causing an audible effect.

8. The method of claim 1, in which determining a value comprises determining an impedance seen at the output of the amplifier.

9. The method of claim 1, also including
comparing the determined value to an expected value for the one or more speakers.

10. The method of claim 9, in which the expected value comprises an impedance of the one or more speakers.

11. The method of claim 10, in which the expected value comprises an impedance of the one or more speakers operating at a frequency of a signal driving the amplifier.

12. The method of claim 1, in which the state of connection includes two speakers connected to the output of the amplifier.

13. The method of claim 1, in which driving the amplifier in a predefined manner comprises applying at least one probing signal.

14. The method of claim 13, in which two speakers are connected to the channel and more than one probing signal is used to drive the amplifier.

15. The method of claim 13, in which the probing signal is selected to be outside a normal range of hearing.

16. The method of claim 13, in which the probing signal is a single pulse comprising a shape that is selected to minimize an audible effect of energizing a drive coil of a DC-connected speaker.

17. The method of claim 1, in which the change comprises an input supply current change of the amplifier.

18. The method of claim 1, in which determining the value comprises performing noise rejection.

19. The method of claim 18, in which performing noise rejection comprises performing noise rejection using synchronized demodulation.

20. The method of claim 18, in which performing noise rejection comprises performing noise rejection using correlation analysis.

21. A system comprising
an amplifier having a speaker output, a drive signal input, and a power input, and
a circuit connected to determine whether and which speaker or speakers are connected to the speaker output based on a detected amount of power being drawn at the power input.

22. The system of claim 21, also including
a current supply electrically connected to the power input of the amplifier.

23. The system of claim 22, in which the circuit comprises an inductor across which a voltage measurement can be made, the inductor being electrically connected between the current supply and the power input of the amplifier.

24. The system of claim 23, in which the inductor comprises a low resistance portion and a low inductance portion.

25. The system of claim 22, in which the circuit comprises a resistive circuit board trace with two points between which a voltage drop can be measured, the resistive circuit board trace being electrically connected between the current supply and the power input of the amplifier.

26. The system of claim 21, in which the circuit comprises a signal measurement module.

27. The system of claim 21, in which the circuit detects the amount of power being drawn at the power input of the amplifier by sensing an amount of power transmitted from a power supply electrically connected to the power input of the amplifier.

28. The system of claim 21, comprising:
an apparatus including the amplifier,
wherein the circuit detects the amount of power being drawn at the power input of the amplifier by sensing an amount of power drawn at a power input of the apparatus.

29. The system of claim 28, wherein the amplifier is a first amplifier, the system comprising:
a second amplifier that is included in the apparatus, the first and second amplifiers each having one or more speaker outputs and being capable of being driven independently,
wherein the circuit is configured to sense an amount of power drawn at a power input of the apparatus while driving each amplifier independently, making it possible to diagnose output faults each output channel of each amplifier using the sensed power at the apparatus.

30. A computer program product, tangibly embodied in an information carrier, for detecting connectivity of a speaker, the computer program product comprising instructions operable to cause data processing apparatus to:
drive a channel of an amplifier with at least one probing signal;
receive a measurement signal indicative of a change to an input supply signal of the amplifier;
calculate a predefined quantity based on the measurement signal; and
compare the determined predefined quantity to an expected value.

31. The computer program product of claim 30, wherein the instructions are further operable to cause the data processing apparatus to define a predetermined frequency for the probing signal.

32. The computer program product of claim 31, wherein the instructions are further operable to cause the data processing apparatus to define the expected value using an impedance of the speaker operating at the predetermined frequency.

33. The computer program product of claim 31, wherein the instructions are further operable to cause the data processing apparatus to define the expected value using an impedance of a first speaker and a second speaker operating at the predetermined frequency, the first and the second speakers being electrically connected to the channel.
